# EUROPEAN PATENT APPLICATION

(11) **EP 4 429 423 A1**
(43) Date of publication of application: **11.09.2024**
(21) Application number: 22903231.3
(22) Date of filing: 25.11.2022
(51) Int. Cl.: H05K 7/20

(54) **HEAT CONDUCTION STRUCTURE AND PREPARATION METHOD THEREFOR, RADIATOR AND ELECTRONIC DEVICE HAVING SAME**

(30) Priority: 07.12.2021 CN 202111483825
(71) Applicant: Huawei Technologies Co., Ltd., Shenzhen, Guangdong 518129 (CN)
(72) Inventor: YUAN, Wenwen, Shenzhen, Guangdong 518129 (CN); SHI, Mingbo, Shenzhen, Guangdong 518129 (CN)
(74) Representative: Körber, Martin Hans
(86) International application number: PCT/CN2022/134229
(87) International publication number: WO 2023/103808

(57) **Abstract**

This application relates to the field of heat dissipation technologies, and in particular, to a thermally conductive structure and a manufacturing method thereof, a heat sink, and an electronic device including the heat sink. The thermally conductive structure includes a thermally conductive plate and a first capillary structure formed by using an electrochemical deposition process. The first capillary structure is disposed on a side that is of the thermally conductive plate and that is opposite to a heat source. The first capillary structure has a plurality of media pores with different pore sizes, the plurality of media pores all extend along a thickness direction of the first capillary structure, and the plurality of media pores all run through the first capillary structure. The thermally conductive structure in this application can prevent untimely liquid flowback and resolve a problem of an excessively high temperature difference at a high heat flux density, thereby improving applicability and heat dissipation effect of the thermally conductive structure.

## Description

### CROSS-REFERENCE TO RELATED APPLICATIONS

This application claims priority to Chinese Patent Application No. 202111483825.X, filed with the China National Intellectual Property Administration on December 7, 2021 and entitled "THERMALLY CONDUCTIVE STRUCTURE AND MANUFACTURING METHOD THEREOF, HEAT SINK, AND ELECTRONIC DEVICE INCLUDING HEAT SINK", which is incorporated herein by reference in its entirety.

### TECHNICAL FIELD

This application relates to the field of heat dissipation technologies, and in particular, to a thermally conductive structure and a manufacturing method thereof, a heat sink, and an electronic device including the heat sink.

### BACKGROUND

In the communication industry, power consumption of a data communication chip, a CPU (central processing unit/processor, central processing unit) chip, a main computing chip, and the like is increasing. Currently, a mainstream power consumption of a chip is from 200 W to 600 W, and tends to evolve towards 800 W, which leads to an increasingly high heat dissipation requirement of the chip.

Currently, in the industry, high heat of a chip is spread mainly through a phase change of a working medium (usually deionized water) inside a VC (vapour chamber, vapour cavity, heat equalizing plate, and flat heat pipe) heat sink, to significantly reduce a thermal resistance of a system, to improve heat dissipation efficiency. However, when the VC heat sink works in a low-temperature scenario, a resistance of water vapor increases sharply, or when the VC heat sink works in a scenario in which a heat flux density is excessively high, untimely liquid flowback easily occurs inside the VC heat sink, which results in dry burning and increases a chip temperature.

A capillary wick inside the VC heat sink is used as a channel for transporting the working medium of water, and has functions of heat transfer and mass transfer, provides a liquid flowback driving force, and increases a liquid flow resistance. In addition, in addition to surface evaporation, boiling heat transfer occurs during phase transition of the working medium of water at a high heat flux density. A conventional sintered capillary wick (sintered copper powder/sintered copper mesh) structure has disadvantages such as an insufficient capillary driving force or a high liquid resistance, and a boiling heat transfer coefficient is not high, which is a bottleneck of a VC heat sink at a high heat flux density.

Therefore, a new thermally conductive structure is urgently needed to resolve the foregoing technical problems.

### SUMMARY

This application provides a thermally conductive structure, a manufacturing method thereof, a heat sink, and an electronic device including the heat sink, to prevent untimely liquid flowback, and resolve a problem that a temperature difference is excessively high because a conventional sintered capillary structure has a low boiling heat transfer coefficient at a high heat flux density, thereby improving applicability and heat dissipation effect of the thermally conductive structure.

According to a first aspect, this application provides a thermally conductive structure, including a thermally conductive plate and a first capillary structure formed by using an electrochemical deposition process, where the first capillary structure is disposed on a side that is of the thermally conductive plate and that is opposite to a heat source, the first capillary structure has a plurality of media pores with different pore sizes, the plurality of media pores all extend along a thickness direction of the first capillary structure, and the plurality of media pores all run through the first capillary structure. When the thermally conductive plate absorbs heat generated by the heat source and cools the heat source, a working medium boils in a process of continuously absorbing heat transferred by the thermally conductive plate, and bubbles generated when the working medium is boiling may quickly escape through media pores in the first capillary structure, so that the working medium can quickly flow back, thereby reducing a temperature of a chip.

It should be noted that the pore sizes of the media pores may be 1 µm to 250 µm, where the pore sizes of the media pores may be specifically 50 µm, 120 µm, 180 µm, or the like, and a plurality of media pores form a honeycomb-like shape. When the pore sizes of the media pores are 1 µm to 250 µm, the bubbles generated when the working medium is boiling can quickly escape through the media pores, which improves a circulation speed of the working medium.

In a possible embodiment, to improve a capillary force of the first capillary structure, a gap used to connect two adjacent media pores may be provided between at least some media pores in a plurality of media pores with different pore sizes. The gap may be a pore, and a size of the gap may be 0.01 µm to 10 µm, that is, the size of the gap is in a micrometer or sub-micrometer scale. In this way, when the working medium is boiling at a high temperature, in the first capillary structure, more nucleation sites may be formed, and then more bubbles are formed, which is conducive to circulation of the working medium inside the heat sink, and further reduces a temperature difference between the thermally conductive plate and the cover plate.

In a possible embodiment, the first capillary structure further includes a plurality of first connection walls and a plurality of second connection walls, and the plurality of media pores with different pore sizes are enclosed through interconnection between the plurality of first connection walls, between the plurality of second connection walls, and between the plurality of first connection walls and the plurality of second connection walls. To ensure that the working medium can have a relatively large quantity of nucleation sites and have a relatively large quantity of bubbles when boiling, and the first capillary structure can accommodate a relatively large quantity of working medium, a wall thickness of the first connection wall may be 20 µm to 300 µm, and a thickness of the second connection wall may be 1 µm to 20 µm.

In a possible embodiment, to connect first connection walls and second connection walls, the first capillary structure may further include a connection neck, and the connection neck may connect adjacent first connection walls, adjacent second connection walls, and a first connection wall and a second connection wall that are adjacent to each other, to form the first capillary structure. A diameter of the connection neck may be 0.01 µm to 20 µm, and a ratio of a length of the connection neck to the diameter of the connection neck is less than 10. Disposing the connection neck may enhance strength of the first capillary structure.

In a possible embodiment, the first connection wall may include a plurality of first subwalls, the first subwalls may be flat-shaped or rod-shaped, but the first subwalls are not limited to being flat-shaped or rod-shaped. Specifically, when the first subwall is rod-shaped, a diameter of the first subwall is 0.1 µm to 10 µm, and a length of the first subwall is 0.1 µm to 10 µm. When the first subwall is flat-shaped, in the plurality of first subwalls, a sphere is disposed on the first subwall located at an end, where a thickness of the first subwall may be 0.1 µm to 10 µm, and a diameter of the sphere may be 0.01 µm to 10 µm.

In a possible embodiment, the second connection wall may include a plurality of second subwalls, the second subwalls may be flat-shaped or rod-shaped, and the second subwalls are not limited to being flat-shaped or rod-shaped. Specifically, when the second subwall is rod-shaped, a diameter of the second subwall is 0.1 µm to 10 µm, and a length of the second subwall may be 0.1 µm to 10 µm. When the second subwall is flat-shaped, in the plurality of second subwalls, a sphere may be further disposed on the second subwall located at an end of the first connection wall, where a thickness of the second subwall may be 0.1 µm to 10 µm, and a diameter of the sphere may be 0.01 µm to 10 µm. That is, the second connection wall may have a same structure as the first connection wall.

In a possible embodiment, to improve a capillary force of the thermally conductive structure and enable the thermally conductive structure can be used for heat dissipation in a scenario in which the heat flux density is 150 W/cm², the first capillary structure may completely cover a side that is of the thermally conductive plate and that is opposite to the heat source.

In a possible embodiment, the thermally conductive plate may include a core area and a non-core area. The core area is used to correspond to the heat source, and the first capillary structure covers at least the core area. The thermally conductive structure may further include a second capillary structure, and the second capillary structure may be disposed on a side that is of the non-core area and that is opposite to the heat source. The second capillary structure may at least partially overlap with the first capillary structure. The first capillary structure coincides with the second capillary structure, so that after the working medium in the first capillary structure boils, the working medium in the second capillary structure can be quickly supplemented to the first capillary structure, which is more conducive to backflow of the working medium.

It should be noted that a length of an overlapping area between the second capillary structure and the first capillary structure may be 1 mm to 5 mm.

In a possible embodiment, a thickness of the first capillary structure may be 0.3 mm to 1.8 mm, and a thickness of the second capillary structure may be 0.5 mm to 1.0 mm, to ensure that the resistance of the working medium flowing in the first capillary structure and the second capillary structure and a heat transfer coefficient of the working medium are within proper ranges.

It should be noted that the thermally conductive structure in any one of the foregoing technical solutions may be applied to a VC heat sink, a loop heat pipe heat sink, or a thermosiphon heat sink, and the thermally conductive structure may also be applied to other types of heat sinks, which are not listed herein.

According to a second aspect, this application further provides a method for manufacturing a thermally conductive structure, including: obtaining a thermally conductive plate; removing impurities from a surface of the thermally conductive plate; preparing an electrodeposition solution; and forming, by using an electrochemical deposition process, a first capillary structure on the thermally conductive plate from which the impurities are removed, where the first capillary structure has a plurality of media pores with different pore sizes, the plurality of media pores all extend along a thickness direction of the first capillary structure, and the plurality of media pores all run through the first capillary structure.

In a process of forming the thermally conductive structure in the foregoing manner, both hydrogen ions and copper ions in the electrodeposition solution need to obtain electrons. After the hydrogen ions obtain electrons, hydrogen bubbles are formed. After the copper ions obtain electrons, the copper bubbles form copper crystal branches. The copper crystal branches are continuously deposited on the thermally conductive plate. In a process in which the hydrogen bubbles escape, a plurality of through pores (media pores) are formed on the copper crystal branches to form the first capillary structure on the thermally conductive plate, the first capillary structure has a plurality of media pores with different pore sizes, and the plurality of media pores extend along a thickness direction of forming the first capillary structure and run through the first capillary structure, so that bubbles generated when the working medium is boiling can quickly escape through the media pores, and the thermally conductive structure can dissipate heat for a heat source with higher power.

It should be noted that the step of forming, by using an electrochemical deposition process, a first capillary structure on the thermally conductive plate from which the impurities are removed may include: placing the thermally conductive plate from which the impurities are removed and the electrodeposition solution in an electrodeposition groove; disposing an anode plate opposite to a core area of the thermally conductive plate in the electrodeposition groove; feeding a constant current into the electrodeposition solution within specified duration; and taking out the thermally conductive plate from the electrodeposition solution for washing with water and drying to form the first capillary structure on the thermally conductive plate.

The specified duration may be 5 minutes to 15 minutes, and a constant current may be 0.3 A/cm² to 1.0 A/cm².

The step of preparing an electrodeposition solution includes: mixing copper sulfate and sulfate according to a specific proportion to form the electrodeposition solution. Specifically, an additive may be added to the solution formed by the copper sulfate and the sulfate, where the additive may be specifically a trace amount of one or more of sodium chloride, sodium dodecyl acid, and sodium dodecyl sulfate.

According to a third aspect, this application further provides a method for manufacturing a thermally conductive structure, including: obtaining a thermally conductive plate; removing impurities from a non-core area of the thermally conductive plate, and sintering a second capillary structure in the non-core area; removing impurities from a core area of the thermally conductive plate; preparing an electrodeposition solution; and forming, by using an electrochemical deposition process, a first capillary structure on the thermally conductive plate from which the impurities are removed, where the first capillary structure has a plurality of media pores with different pore sizes, the plurality of media pores all extend along a thickness direction of the first capillary structure, and the plurality of media pores all run through the first capillary structure.

In a process of forming the thermally conductive structure in the foregoing manner, both hydrogen ions and copper ions in the electrodeposition solution need to obtain electrons. After the hydrogen ions obtain electrons, hydrogen bubbles are formed. After the copper ions obtain electrons, the copper bubbles form copper crystal branches. The copper crystal branches are continuously deposited on the thermally conductive plate. In a process in which the hydrogen bubbles escape, a plurality of through pores (media pores) are formed on the copper crystal branches to form the first capillary structure on the thermally conductive plate, the first capillary structure has a plurality of media pores with different pore sizes, so that bubbles generated when the working medium is boiling can quickly escape through the media pores, and the thermally conductive structure can dissipate heat for a heat source with higher power.

It should be noted that the step of forming, by using an electrochemical deposition process, a first capillary structure on the thermally conductive plate from which the impurities are removed may include: placing the thermally conductive plate from which the impurities are removed and the electrodeposition solution in an electrodeposition groove; disposing an anode plate opposite to a core area of the thermally conductive plate in the electrodeposition groove; feeding a constant current into the electrodeposition solution within specified duration; and taking out the thermally conductive plate from the electrodeposition solution for washing with water and drying to form the first capillary structure in the core area.

The specified duration may be 5 minutes to 15 minutes, and a constant current may be 0.3 A/cm² to 1.0 A/cm².

In a possible embodiment, the step of preparing an electrodeposition solution includes: mixing copper sulfate, sulfuric acid, and pure water at a specific proportion to form the electrodeposition solution. Specifically, a trace amount of one or more of sodium chloride, sodium dodecyl acid, and sodium dodecyl sulfate may be added to the solution formed by the copper sulfate, the sulfuric acid, and the pure water.

In a possible embodiment, to ensure that the first capillary structure deposited in the core area of the thermally conductive plate may have an overlapping area with the second capillary structure in the non-core area of the thermally conductive plate, a ratio of an area of the core area of the thermally conductive plate to an area of the anode plate may be 1:0.8 to 1:10.

According to a fourth aspect, this application further includes a heat sink, including a cover plate, a pillar, and the thermally conductive structure in any one of the foregoing technical solutions, where a third capillary structure may be disposed on a side that is of the cover plate and that faces the thermally conductive structure, one end of the pillar may pass through the third capillary structure and be connected to the cover plate, and the other end of the pillar is connected to the thermally conductive structure. The thermally conductive structure may include a thermally conductive plate and a first capillary structure. The thermally conductive plate has a core area used to correspond to a heat source. The first capillary structure is located on a side that is of the thermally conductive plate and that is opposite to the heat source. The first capillary structure covers at least the core area of the thermally conductive plate. The first capillary structure has a plurality of media pores with different pore sizes. Each media pore extends along a thickness direction of the first capillary structure, and each media pore runs through the first capillary structure. When the heat sink dissipates heat for the heat source, heat generated by the heat source is conducted to the core area of the thermally conductive plate, and a temperature of the core area increases. The working medium in the first capillary structure is heated and boils, and bubbles generated by the boiling working medium may quickly pass through the media pores in the first capillary structure, so that the high-temperature working medium quickly reaches an area of the cover plate, thereby improving a boiling heat transfer coefficient of the working medium and a speed of liquid flowback inside the heat sink, and it is ensured that a temperature difference between the thermally conductive plate and the cover plate is relatively low when the heat sink works, thereby improving heat dissipation effect of the heat sink, and preventing a problem that a temperature of the heat source increases due to dry burning of the heat source.

Optionally, the first capillary structure may completely cover a side that is of the thermally conductive plate and that is opposite to the heat source. The thermally conductive structure may also include a second capillary structure, where the second capillary structure covers a non-core area of the thermally conductive plate, and the first capillary structure covers only the core area and areas surrounding the core area.

According to a fifth aspect, this application further provides an electronic device, including a housing, and the heat sink and the heat source that are disposed in the housing in any one of the foregoing solutions. The electronic device may further include other components. Specific types of the other components may be defined based on a specific type of the electronic device, and are not listed herein. The heat sink in any one of the foregoing solutions may enable the electronic device to have a good heat dissipation capability. The heat source may be a chip, a circulation component, a duplexer, a power amplifier, a transmitter, or a power module, and the electronic device may be a data communication electronic device, a router, a wireless base station, a server, or the like.

### BRIEF DESCRIPTION OF DRAWINGS

FIG. 1 is an exploded view of a heat sink according to an embodiment of this application;
FIG. 2 is a diagram of a structure of a thermally conductive structure according to an embodiment of this application;
FIG. 3 is a diagram of a structure of another heat sink according to an embodiment of this application;
FIG. 4 is a diagram of a structure of still another thermally conductive structure according to an embodiment of this application;
FIG. 5 is a micro-morphology of a first capillary structure in a thermally conductive structure at a resolution of 100 µm according to an embodiment of this application;
FIG. 6 is a micro-morphology of a first capillary structure in a thermally conductive structure at a resolution of 2 µm according to an embodiment of this application;
FIG. 7 is a flowchart of a thermally conductive structure according to an embodiment of this application;
FIG. 8 is still another flowchart of a thermally conductive structure according to an embodiment of this application; and
FIG. 9 is a diagram of a structure of an electronic device according to an embodiment of this application.

### Reference numerals:

1: heat sink; 2: housing; 10: thermally conductive plate; 11: first groove; 12: core area; 20: first capillary structure; 21: media pore; 22: first connection wall; 23: second connection wall; 24: connection neck; 25: gap; 30: pillar; 40: cover plate; 50: third capillary structure; 60: powder ring; 70: second capillary structure; 80: heat source; 90: overlapping area.

### DESCRIPTION OF EMBODIMENTS

To make objectives, technical solutions, and advantages of this application clearer, the following further describes this application in detail with reference to accompanying drawings.

Capillary structures in VCs in the conventional technology are mainly sintered copper powder structures or sintered copper mesh structures, and a small quantity of structures in which copper mesh and copper powder are sintered together. These sintered copper powder structures, sintered copper mesh structures, and structures in which copper meshes and copper powder are usually sintered are generally solid structures formed by connecting mutually separated powder/copper wire meshes in a high temperature (greater than or equal to 900°C) condition.

However, the capillary structure formed through sintering in the foregoing manner has the following disadvantages:

First, there is a contradiction between a capillary force and permeability, and the contradiction is difficult to reconcile. For example, a conventional capillary structure formed by sintering copper powder or a copper mesh with a mesh size equal to or less than 250 is selected, and a pore structure size is relatively uniform, a pore size is greater than 10 µm, a capillary force is less than 2000 Pa, and a liquid flowback driving force is insufficient. If smaller powder or a copper wire mesh is selected to form a capillary structure, a smaller pore size increases the capillary force, but the permeability is excessively high, that is, a resistance of liquid flowback is high.

Second, in a capillary structure formed by sintering copper powder or sintering a copper mesh, bubbles formed in a high flux scenario escape from the inside out through a winding path, making it difficult for the bubbles to escape. As a result, a corresponding boiling heat transfer coefficient is not high in the high heat flux scenario.

To resolve the foregoing problems, this application provides a thermally conductive structure, to prevent untimely liquid flowback, and resolve a problem that a temperature difference is excessively large because a conventional sintered capillary has a low boiling heat transfer coefficient at a high heat flux density, thereby improving applicability and heat dissipation effect of the thermally conductive structure.

Terms used in the following embodiments are merely intended to describe particular embodiments, but are not intended to limit this application. The terms "one", "a", "the", "the foregoing", "this", and "the one" of singular forms used in this specification and the appended claims of this application are also intended to include forms such as "one or more", unless otherwise specified in the context clearly.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

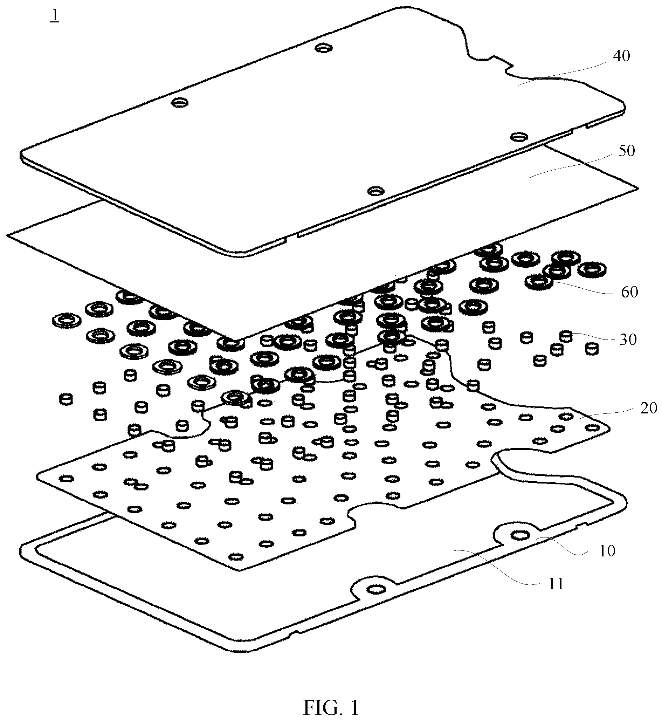

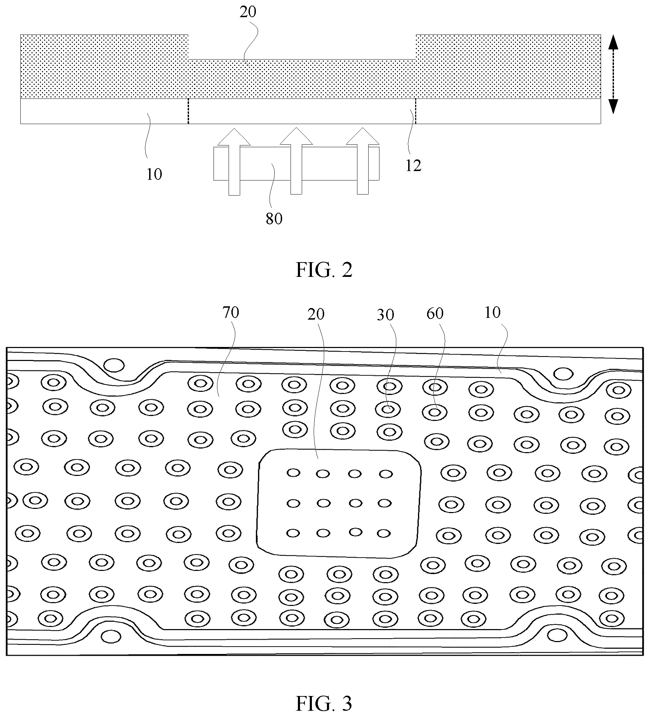

Refer to FIG. 1 and FIG. 2. A dashed arrow in FIG. 2 is a thickness direction of a first capillary structure 20. This application provides a heat sink. The heat sink 1 may include a cover plate 40, a thermally conductive structure, and a plurality of pillars 30. The plurality of pillars 30 may be disposed between the cover plate 40 and the thermally conductive structure, and two ends of each of the plurality of pillars 30 are respectively connected to the cover plate 40 and the thermally conductive structure. The thermally conductive structure may include a thermally conductive plate 10 and a first capillary structure 20 formed by using an electrochemical deposition process. The thermally conductive plate 10 is provided with a core area 12 corresponding to a heat source 80. The first capillary structure 20 is disposed on a side that is of the thermally conductive plate 10 and that is opposite to the heat source 80. The first capillary structure 20 completely covers a side that is of the thermally conductive plate 10 and that is opposite to the heat source 80. The first capillary structure 20 has a plurality of media pores with different pore sizes, the plurality of media pores all extend along the thickness direction of the first capillary structure 20, and the plurality of media pores all run through the first capillary structure 20. When the heat sink 1 dissipates heat for the heat source 80, heat generated by the heat source 80 is conducted to the core area 12 of the thermally conductive plate 10, and a temperature of the core area 12 increases. A working medium located in the first capillary structure 20 is heated and boils, and bubbles generated by the boiling working medium may quickly pass through the media pores in the first capillary structure 20, so that the high-temperature working medium quickly reaches the cover plate 40. In this way, a boiling heat transfer coefficient of the working medium and a speed of liquid flowback inside the heat sink 1 are improved, and it is ensured that a temperature difference between the thermally conductive plate 10 and the cover plate 40 is relatively low when the heat sink 1 is working, thereby improving heat dissipation effect of the heat sink 1 and preventing dry burning of the heat source.

It should be noted that the heat sink 1 may be used in a scenario in which a heat flux density of the heat source 80 reaches 150 W/cm². In addition, when the thermally conductive plate 10 and the cover plate 40 are specifically disposed, a first groove 11 may be disposed in the thermally conductive plate 10, an opening of the first groove 11 faces the cover plate 40, and the first capillary structure 20 is located in the first groove 11. A second groove (not shown in FIG. 1) may be disposed in the cover plate 40, and an opening of the second groove faces the thermally conductive plate 10. A third capillary structure 50 may be disposed in the second groove, the third capillary structure 50 corresponds to the first capillary structure 20, and the first capillary structure 20 and the third capillary structure 50 are both provided with through pores for the pillars 30 to pass through. When the thermally conductive plate 10 is connected to the cover plate 40, a side wall of the first groove 11 may be fastened to a side wall of the second groove. The through pores disposed on the first capillary structure 20 one-to-one correspond to the through pores disposed on the third capillary structure 50, and the through pores disposed on the first capillary structure 20 and the through pores disposed on the third capillary structure 50 may be evenly distributed.

In the foregoing embodiment, the heat sink 1 may further include a plurality of powder rings 60, each pillar 30 is sleeved with a powder ring 60, the powder rings 60 are located between the first capillary structure 20 and the third capillary structure 50, and a thickness of the powder ring 60 is a spacing between the first capillary structure 20 and the third capillary structure 50. The working medium condensed on the cover plate 40 passes through the pores in the third capillary structure 50 and enters the first capillary structure 20 along an outer wall of the powder ring 60. In this process, the powder ring 60 may implement a flow guiding function.

Refer to FIG. 1, FIG. 3, and FIG. 4. This application further provides another heat sink, which may include a cover plate 40, a thermally conductive structure, and a plurality of pillars 30. The plurality of pillars 30 may be disposed between the cover plate 40 and the thermally conductive structure, and two ends of each of the plurality of pillars 30 are respectively connected to the cover plate 40 and the thermally conductive structure. The thermally conductive structure may include a thermally conductive plate 10, a first capillary structure 20, and a second capillary structure 70. The first capillary structure 20 is formed by using an electrochemical deposition process. The thermally conductive plate 10 is provided with a core area 12 that is used to correspond to a heat source 80. The first capillary structure 20 and the second capillary structure 70 are both disposed on a side that is of the thermally conductive plate 10 and that is opposite to the heat source 80. The first capillary structure 20 corresponds to the core area 12, and the second capillary structure 70 corresponds to an area (non-core area) outside the core area 12. The first capillary structure 20 has a plurality of media pores with different pore sizes, the plurality of media pores all extend along a thickness direction of the first capillary structure 20, and the plurality of media pores all run through the first capillary structure 20. When the heat sink dissipates heat for the heat source 80, heat generated by the heat source 80 is conducted to the core area 12 of the thermally conductive plate 10, and a temperature of the core area 12 increases. A working medium located in the first capillary structure 20 is heated and boils, and bubbles generated by the boiling working medium may quickly pass through the media pores in the first capillary structure 20, so that the high-temperature working medium quickly reaches the cover plate 40. In this way, a boiling heat transfer coefficient of the working medium and a speed of liquid flowback inside the heat sink are improved, and it is ensured that a temperature difference between the thermally conductive plate 10 and the cover plate 40 is relatively low when the heat sink is working, thereby improving heat dissipation effect of the heat sink, and preventing a problem that the heat source is overheated due to dry burning of the heat source.

It should be noted that, in the foregoing heat sink, the boiling working medium may quickly pass through the first capillary structure 20 through the media pores in the first capillary structure 20, which may increase a boiling heat transfer coefficient of the working medium by 50%. In addition, the foregoing heat sink may be used in a scenario in which a heat flux density of the heat source 80 reaches 100 W/cm², and a temperature difference between the thermally conductive plate 10 and the cover plate 40 decreases by 3°C to 8°C. When the thermally conductive plate 10 and the cover plate 40 are specifically disposed on the apparatus, a first groove 11 may be disposed on the thermally conductive plate 10, an opening of the first groove 11 faces the cover plate 40, and the first capillary structure 20 and the second capillary structure 70 are located in the first groove 11. A second groove may be disposed on the cover plate 40, and an opening of the second groove faces the thermally conductive plate 10. A third capillary structure 50 may be disposed in the second groove, the third capillary structure 50 corresponds to the first capillary structure 20 and the second capillary structure 70, and the first capillary structure 20, the second capillary structure 70, and the third capillary structure 50 are all provided with through pores for the pillars 30 to pass through. When the thermally conductive plate 10 is connected to the cover plate 40, a side wall of the first groove 11 may be fastened to a side wall of the second groove. On the thermally conductive plate 10, the first capillary structure 20 may be in a shape of a rectangle, a circle, or a rhombus, and the first capillary structure 20 may be wrapped by the second capillary structure 70.

In the foregoing embodiment, a structure of the second capillary structure 70 may be the same as a structure of the third capillary structure 50. In addition, to ensure backflow of the working medium inside the first capillary structure 20, the first capillary structure 20 and the second capillary structure 70 may at least partially overlap, so that the first capillary structure 20 and the second capillary structure 70 that are disposed on the thermally conductive plate 10 communicate with each other.

It should be noted that a length of an overlapping area 90 between the first capillary structure 20 and the second capillary structure 70 may be 1 mm to 5 mm. In addition, a thickness of the second capillary structure 70 may be 0.5 mm to 1.0 mm, and a flow resistance of the working medium in the second capillary structure 70 is inversely proportional to the thickness of the second capillary structure 70, that is, when the thickness of the second capillary structure 70 increases, the flow resistance of the working medium in the second capillary structure 70 decreases. However, when the thickness of the second capillary structure 70 increases, the gap between the second capillary structure 70 and the third capillary structure 50 decreases. In this case, the working medium flows to the gap, and a resistance of the air increases. In addition, if the second capillary structure 70 is thicker, the boiling heat transfer coefficient of the working medium is smaller. Therefore, the thickness of the second capillary structure 70 ranges from 0.5 mm to 1.0 mm, which can ensure that the resistance of the working medium flowing in the second capillary structure 70 and a heat transfer coefficient of the working medium are within proper ranges.

In a possible embodiment, the heat sink further includes a plurality of powder rings 60, each pillar 30 is sleeved with a powder ring 60, the powder rings 60 are located between the first capillary structure 20 and the third capillary structure 50 and between the second capillary structure 70 and the third capillary structure 50, and a thickness of the powder ring 60 is equal to a spacing between the first capillary structure 20 and the third capillary structure 50, and is equal to a distance between the second capillary structure 70 and the third capillary structure 50. The working medium condensed on the cover plate 40 passes through the pores in the third capillary structure 50, and enters the first capillary structure 20 and the second capillary structure 70 along an outer wall of the powder ring. In this process, the powder ring may implement a flow guiding function.

In the foregoing embodiment, the thickness of the first capillary structure 20 may be 0.3 mm to 1.8 mm, and a principle for setting the thickness of the first capillary structure 20 is the same as a principle for setting the second capillary structure 70.

The following describes the first capillary structure in detail.

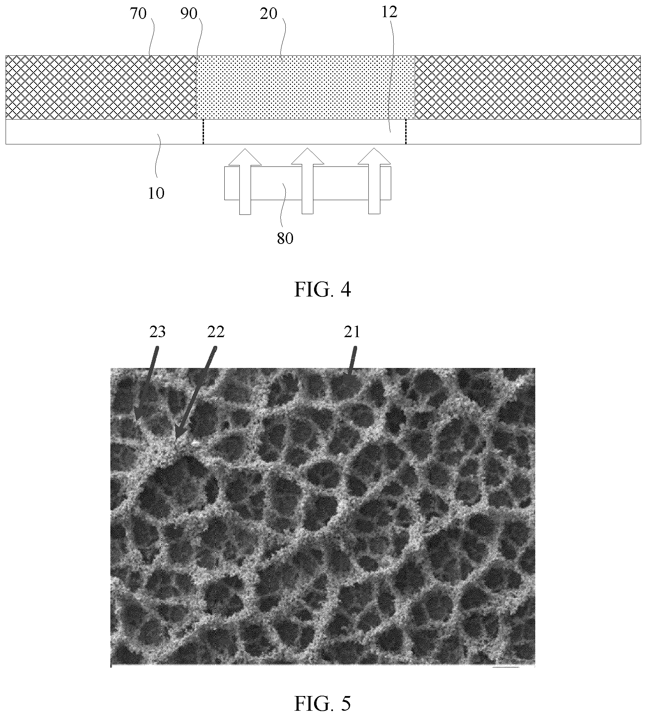

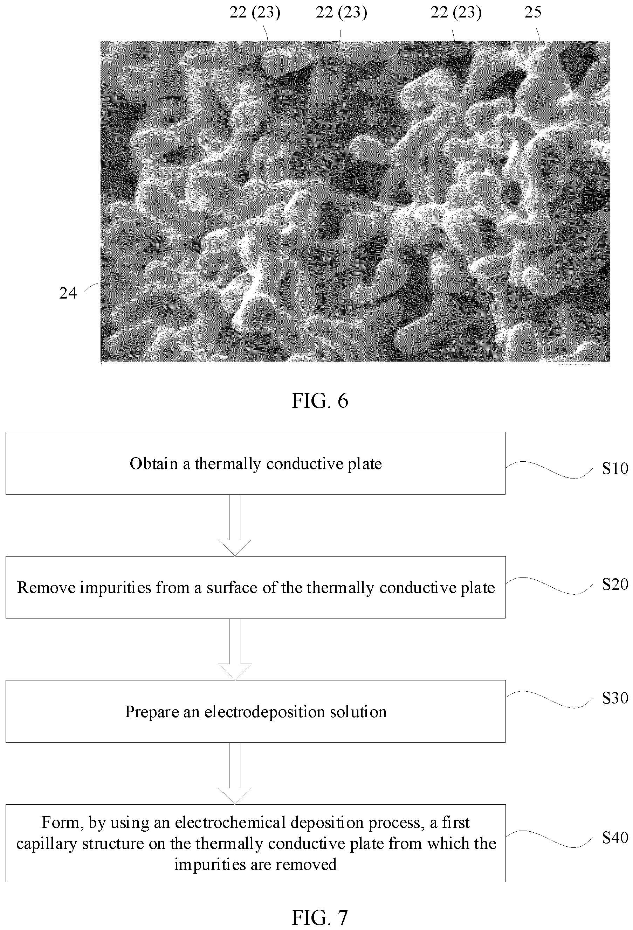

Refer to FIG. 5 and FIG. 6. Pore sizes of media pores 21 on the first capillary structure 20 may be 1 µm to 250 µm, and a plurality of media pores 21 of different sizes may form honeycomb-like shape. Because the pore sizes of the media pores 21 are 1 µm to 250 µm, bubbles generated when the working medium in the first capillary structure 20 is boiling may quickly escape through the media pores 21, which improves a circulation speed of the working medium. When the pore sizes of the media pores 21 are less than 1 µm, because the pore sizes of the media pores 21 are relatively small, it is very difficult for the bubbles generated when the working medium is boiling to escape through the media pores 21. When the pore sizes of the media pores 21 are greater than 250 µm, because the pore wall of each media pore 21 is relatively thin, a quantity of effective nucleation sites of the bubbles when the working medium is boiling is reduced, thereby significantly reducing a quantity of formed bubbles. As a result, a relatively large temperature difference occurs between the cover plate 40 and the thermally conductive plate 10, that is, the superheat degree is increased, and the heat sink cannot effectively dissipate heat for the heat source.

In a possible embodiment, a gap 25 used to connect two adjacent media pores 21 is provided between at least some of the plurality of media pores 21 with different pore sizes. The gap 25 may be a pore, and a size of the gap 25 may be 0.01 µm to 10 µm. The gap 25 provided between two of some adjacent media pores 21 can significantly improve a capillary force of the first capillary structure 20. In addition, when the first capillary structure 20 covers a side that is of the thermally conductive plate 10 and that is opposite to the heat source 80, the capillary force of the first capillary structure 20 may increase by 50%.

It should be noted that the size of the gap 25 may be 0.01 µm to 10 µm, that is, the size of the gap 25 is in a micrometer or sub-micrometer scale. In this way, when the working medium is boiling at a high temperature, more nucleation sites may be formed in the first capillary structure 20, and then more bubbles are formed, which is conducive to circulation of the working medium inside the heat sink, and further reduces a temperature difference between the thermally conductive plate 10 and the cover plate 40. When the size of the gap 25 is less than 0.01 µm, a resistance of the liquid is excessively high when the liquid passes through the gap. When the size of the gap 25 is greater than 10 µm, the capillary force of the first capillary structure 20 is reduced; and when the size of the gap 25 is greater than 10 µm, the quantity of the nucleation sites of the bubbles is reduced, and the quantity of bubbles generated when the working medium is boiling is reduced. Consequently, the temperature difference between the thermally conductive plate 10 and the cover plate 40 increases, and a heat flux density to which the heat sink is applicable is lower.

In the foregoing embodiment, the first capillary structure 20 may include a plurality of first connection walls 22 and a plurality of second connection walls 23. The plurality of first connection walls 22, the plurality of second connection walls 23, and the plurality of first connection walls 22 and the plurality of second connection walls 23 may be interconnected to form a plurality of media pores 21 with different pore sizes. To ensure that there are a relatively large quantity of nucleation sites and a relatively large quantity of bubbles when the working medium is boiling, and that the first capillary structure 20 can accommodate a relatively large amount of working medium, a wall thickness of the first connection wall 22 may be 20 µm to 300 µm, and a thickness of the second connection wall 23 may be 1 µm to 20 µm. If the wall thickness of the first connection wall 22 and the second connection wall 23 is less than 1 µm, the wall thickness of the connection wall is excessively small. This not only reduces strength of the first capillary structure 20, but also sharply reduces the quantity of nucleation sites generated when the working medium is boiling. Consequently, the quantity of bubbles generated when the working medium is boiling is reduced, and performance of the heat sink is reduced. When the wall thickness of the connection wall is greater than 300 µm, the pore sizes of the media pores 21 in the first capillary structure 20 are reduced. As a result, the amount of working medium that can be accommodated in the first capillary structure 20 is reduced, and a heat dissipation capability of the heat sink is reduced.

In a possible embodiment, the first capillary structure 20 further includes a connection neck 24. The connection neck 24 may connect adjacent first connection walls 22, adjacent second connection walls 23, and a first connection wall 22 and a second connection wall 23 that are adjacent to each other, so that stability of connection between the connection walls is stronger, thereby improving the strength of the first capillary structure 20. Specifically, a diameter of the connection neck 24 may be 0.01 µm to 20 µm, and a ratio of a length of the connection neck 24 to the diameter of the connection neck 24 is less than 10.

In the foregoing embodiment, the first connection wall 22 may include a plurality of first subwalls, and the first subwalls may be flat-shaped or rod-shaped, but the first subwalls are not limited to being flat-shaped or rod-shaped. Specifically, when each first subwall is rod-shaped, a diameter of the first subwall may be 0.1 µm to 10 µm, a length of the first subwall may be 0.1 µm to 10 µm, and a plurality of first subwalls may be stacked to form the first connection wall. When each first subwall is flat-shaped, in the plurality of first subwalls, a sphere is disposed on the first subwall located at an end of the first connection wall 22, where a thickness of the first subwall may be 0.1 µm to 10 µm, and a diameter of the sphere may be 0.01 µm to 10 µm.

It should be noted that a structure of the second connection wall 23 is the same as that of the first connection wall 22, and details are not described herein again.

In the foregoing embodiment, a material of the thermally conductive plate may be a metal monomer such as copper, aluminum, iron, nickel, or silver or an alloy, and a heat source may be a chip.

Based on the diagrams of the structures of the heat sink, the thermally conductive structure, and the first capillary structure that are provided in the embodiments shown in FIG. 1, FIG. 2, FIG. 5, and FIG. 6, this application further provides a method for manufacturing the foregoing thermally conductive structure in the heat sink. Refer to FIG. 7. The method includes the following steps:
S10: Obtain a thermally conductive plate.
S20: Remove impurities from a surface of the thermally conductive plate.
S30: Prepare an electrodeposition solution.

The step of preparing an electrodeposition solution may include: mixing copper sulfate, sulfuric acid, and pure water in a specific proportion to form the electrodeposition solution; and when the copper sulfate, sulfuric acid, and pure water are mixed in a specific proportion, adding a trace amount of one or more of trace sodium chloride, sodium dodecyl acid, and sodium dodecyl sulfate to the formed solution to improve deposition effect.

S40: Form, by using an electrochemical deposition process, a first capillary structure on the thermally conductive plate from which the impurities are removed.

The step of forming, by using an electrochemical deposition process, a first capillary structure on the thermally conductive plate from which the impurities are removed may include: placing the thermally conductive plate from which the impurities are removed and the electrodeposition solution in an electrodeposition groove; disposing an anode plate opposite to a core area of the thermally conductive plate in the electrodeposition groove; feeding a constant current into the electrodeposition solution within specified duration; and taking out the thermally conductive plate from the electrodeposition solution for washing with water and drying to form the first capillary structure on the thermally conductive plate.

The first capillary structure has a plurality of media pores with different pore sizes, the plurality of media pores all extend along a thickness direction of the first capillary structure, and the plurality of media pores all run through the first capillary structure.

In a process of forming the thermally conductive structure in the foregoing manner, both hydrogen ions and copper ions in the electrodeposition solution need to obtain electrons. After the hydrogen ions obtain electrons, hydrogen bubbles are formed. After the copper ions obtain electrons, copper bubbles form copper crystal branches. The copper crystal branches are continuously deposited on the thermally conductive plate. In a process in which the hydrogen bubbles escape, a plurality of through pores (media pores) are formed on the copper crystal branches to form the first capillary structure on the thermally conductive plate, and the first capillary structure has a plurality of media pores with different pore sizes. The plurality of media pores extend along a thickness direction of the formed first capillary structure, and run through the first capillary structure, so that bubbles generated when the working medium is boiling can quickly escape through the media pores, and the thermally conductive structure can dissipate heat for a heat source with higher power.

It should be noted that the specified duration may be 5 minutes to 15 minutes, and a constant current may be 0.3 A/cm² to 1.0 A/cm².

In a possible embodiment, a heat sink may be manufactured based on the foregoing method for manufacturing a thermally conductive structure. Specifically, before the step of removing impurities on a surface of a thermally conductive plate, the following steps are added: stamping a metal plate to form a cover plate, cleaning the cover plate, and sintering a third capillary structure on the cover plate; and after the step of taking out the thermally conductive plate for water washing and drying to form the first capillary structure on the thermally conductive plate, the following steps are added: placing a pillar on a side that is of the thermally conductive plate and that is opposite to the heat source, making the pillar pass through the first capillary structure and the third capillary structure, fastening the cover plate and the thermally conductive plate, and sending the cover plate and the thermally conductive plate to a diffusion welding furnace, sealing the cover plate and the thermally conductive plate through welding, welding a liquid injection pipe, and then performing steps of high temperature reduction, liquid injection, and degassing, to form the heat sink.

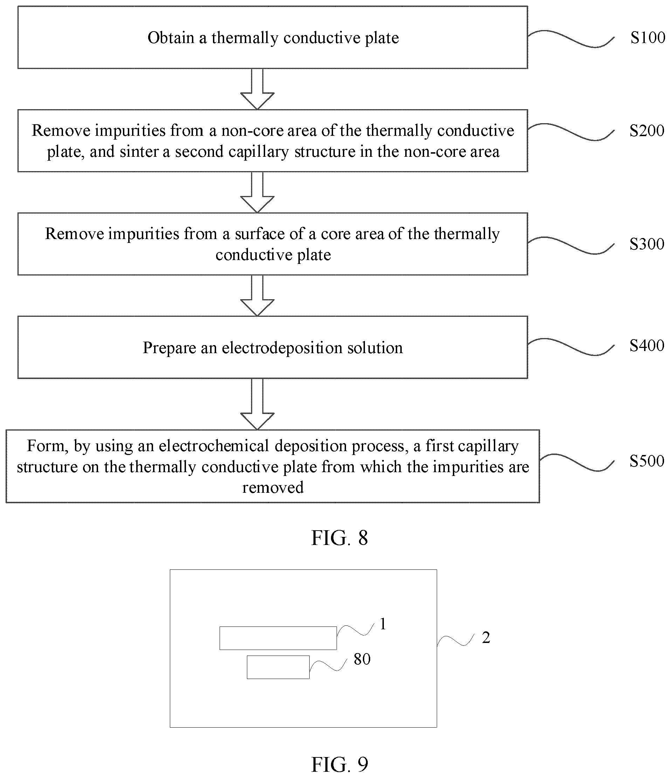

Based on the diagrams of the structures of the heat sink, the thermally conductive structure, and the first capillary structure that are provided in the embodiments shown in FIG. 3 to FIG. 6, this application further provides a method for manufacturing a thermally conductive structure in the foregoing another heat sink. Refer to FIG. 8. The method includes the following steps.

S100: Obtain a thermally conductive plate.

S200: Remove impurities from a non-core area of the thermally conductive plate, and sinter a second capillary structure in the non-core area.

S300: Remove impurities from a surface of a core area of the thermally conductive plate.

S400: Prepare an electrodeposition solution.

The step of preparing an electrodeposition solution may include: mixing copper sulfate, sulfuric acid, and pure water in a specific proportion to form the electrodeposition solution; and when the copper sulfate, sulfuric acid, and pure water are mixed in a specific proportion, adding a trace amount of one or more of trace sodium chloride, sodium dodecyl acid, and sodium dodecyl sulfate to the formed solution to improve deposition effect.

S500: Form, by using an electrochemical deposition process, a first capillary structure on the thermally conductive plate from which the impurities are removed.

The step of forming, by using an electrochemical deposition process, a first capillary structure on the thermally conductive plate from which the impurities are removed may include: placing the thermally conductive plate from which the impurities are removed and the electrodeposition solution in an electrodeposition groove; disposing an anode plate opposite to a core area of the thermally conductive plate in the electrodeposition groove; feeding a constant current into the electrodeposition solution within specified duration; and taking out the thermally conductive plate from the electrodeposition solution for washing with water and drying to form the first capillary structure on the thermally conductive plate.

The first capillary structure has a plurality of media pores with different pore sizes, the plurality of media pores all extend along a thickness direction of the first capillary structure, and the plurality of media pores all run through the first capillary structure.

When the anode plate is disposed, to ensure that the first capillary structure deposited in the core area of the thermally conductive plate may have an overlapping area with the second capillary structure in the non-core area of the thermally conductive plate, a ratio of an area of the core area of the thermally conductive plate to an area of the anode plate is 1:0.8 to 1:10.

In a process of forming the thermally conductive structure in the foregoing manner, both hydrogen ions and copper ions in the electrodeposition solution need to obtain electrons. After the hydrogen ions obtain electrons, hydrogen bubbles are formed. After the copper ions obtain electrons, copper bubbles form copper crystal branches. The copper crystal branches are continuously deposited on the thermally conductive plate. In a process in which the hydrogen bubbles escape, a plurality of through pores (media pores) are formed on the copper crystal branches to form the first capillary structure on the thermally conductive plate, and the first capillary structure has a plurality of media pores with different pore sizes. The plurality of media pores extend along a thickness direction of the formed first capillary structure, and run through the first capillary structure, so that bubbles generated when the working medium is boiling can quickly escape through the media pores, and the thermally conductive structure can dissipate heat for a heat source with higher power.

It should be noted that the specified duration may be 5 minutes to 15 minutes, and a constant current may be 0.3 A/cm² to 1.0 A/cm².

In a possible embodiment, another heat sink may be manufactured based on the foregoing method for manufacturing a thermally conductive structure. Specifically, impurities in a non-core area of the thermally conductive plate are removed, a metal plate is stamped to form a cover plate before the step of sintering the second capillary structure in the non-core area, and a third capillary structure is sintered on the cover plate after the cover plate is cleaned; after the steps of removing impurities from the non-core area of the thermally conductive plate and sintering the second capillary structure in the non-core area, a pillar is placed on a side that is of the thermally conductive plate and that is opposite to a heat source, the pillar is made to pass through the first capillary structure and the third capillary structure, the cover plate and the thermally conductive plate are fastened, and the cover plate and the thermally conductive plate are sent to a diffusion welding furnace, the cover plate and the thermally conductive plate are sealed through welding, a liquid injection pipe is welded, and then steps of high temperature reduction, liquid injection, and degassing are performed, to form the heat sink.

To better describe performance of the first capillary structure in this application, the following compares parameters of the first capillary structure, a capillary structure formed by sintering copper powder, and a capillary structure formed by sintering a copper mesh under conditions of equal thickness, equal width, and equal length with reference to Table 1.

**Table 1**

| Capillary structure | Capillary force | Permeability | Capillary force * Permeability/N |
|---|---|---|---|
| Sintered copper powder | 1300 Pa to 2000 Pa | 3 E-11 m² to 7 E-11 m² | 0.8 E-7 to 1.2 E-7 |
| Sintered copper mesh | 1100 Pa to 1700 Pa | 3 E-11 m² to 10 E-11 m² | 0.8 E-7 to 1.8 E-7 |
| First capillary structure | 3000 Pa to 5500 Pa | 3 E-11 m² to 7 E-11 m² | 1.8 E-7 to 2.2 E-7 |

It can be learned from Table 1 that a capillary force of the first capillary structure in this application is significantly higher than a capillary force of a capillary structure formed by sintering copper powder and a capillary structure formed by sintering a copper mesh. Therefore, when the thermally conductive structure includes the first capillary structure, the thermally conductive structure may have a relatively strong capillary force, to provide a relatively strong driving force for the working medium in the thermally conductive structure, thereby improving a heat dissipation capability of the thermally conductive structure.

Still refer to FIG. 9. This application further provides an electronic device. The electronic device may be a data communication electronic device, a router, a wireless base station, a server, or the like. The electronic device may include a housing 2, and the heat sink 1 and the heat source 80 in any one of the foregoing technical solutions. Based on a specific type of the electronic device, the electronic device may further include other components, which are not listed herein. The heat source 80 may be a chip, a circulation component, a duplexer, a power amplifier, a transmitter, or a power module (but not limited to the chip, the circulation component, the duplexer, the power amplifier, the transmitter, or the power module). The chip, the circulation component, the duplexer, the power amplifier, the transmitter, or the power module may be disposed in the housing, and is thermally connected to the heat sink 1 disposed in the housing 2. When the heat source 80 works, generated heat may be transferred to the thermally conductive plate 10 of the heat sink 1. A working medium in a first capillary structure 20 located on a side of the thermally conductive plate 10 is heated and boils, and bubbles generated by the boiling working medium may quickly pass through media pores in the first capillary structure 20, so that the high-temperature working medium quickly reaches a cover plate 40, thereby improving a boiling heat transfer coefficient of the working medium and a speed of liquid flowback inside the heat sink 1, improving heat dissipation of the heat sink 1, preventing dry burning of the heat source, and improving working stability of the electronic device. The foregoing descriptions are merely specific implementations of this application, but are not intended to limit a protection scope of this application. Any variation or replacement readily figured out by a person skilled in the art within the technical scope disclosed in this application shall fall within the protection scope of this application. Therefore, the protection scope of this application shall be subject to a protection scope of the claims.

## Claims

1. A thermally conductive structure, comprising:
a thermally conductive plate; and
a first capillary structure formed by using an electrochemical deposition process, wherein the first capillary structure is disposed on a side that is of the thermally conductive plate and that is opposite to a heat source, wherein
the first capillary structure has a plurality of media pores with different pore sizes, the plurality of media pores all extend along a thickness direction of the first capillary structure, and the plurality of media pores all run through the first capillary structure.

2. The thermally conductive structure according to claim 1, wherein the pore sizes of the media pores are 1 µm to 250 µm.

3. The thermally conductive structure according to claim 1 or 2, wherein a gap used to connect two adjacent media pores is provided between at least some of the plurality of media pores with different pore sizes.

4. The thermally conductive structure according to claim 3, wherein the first capillary structure further comprises a plurality of first connection walls and a plurality of second connection walls, and the plurality of media pores with different pore sizes are enclosed through interconnection between the plurality of first connection walls, between the plurality of second connection walls, and between the plurality of first connection walls and the plurality of second connection walls.

5. The thermally conductive structure according to claim 4, wherein the gap comprises a first gap and a second gap, the first gap is provided in the first connection wall, the first gap extends along a thickness direction of the first connection wall and runs through the first connection wall, the second gap is provided in the second connection wall, and the second gap extends along a thickness direction of the second connection wall and runs through the second connection wall.

6. The thermally conductive structure according to claim 4 or 5, wherein the first capillary structure further comprises a connection neck, and the connection neck is configured to connect adjacent first connection walls, adjacent second connection walls, and a first connection wall and a second connection wall.

7. The thermally conductive structure according to any one of claims 4 to 6, wherein the first connection wall comprises a plurality of first subwalls, and the first subwalls are flat-shaped or rod-shaped.

8. The thermally conductive structure according to claim 7, wherein when the first subwalls are flat-shaped, in the plurality of first subwalls, a sphere is disposed on the first subwall located at an end of the first connection wall.

9. The thermally conductive structure according to any one of claims 1 to 8, wherein the first capillary structure covers the thermally conductive plate.

10. The thermally conductive structure according to any one of claims 1 to 8, wherein the thermally conductive plate comprises a core area and a non-core area, the core area corresponds to the heat source, and the first capillary structure covers at least the core area; and the thermally conductive structure further comprises a second capillary structure, the second capillary structure is disposed on the side that is of the thermally conductive plate and that is opposite to the heat source, and the second capillary structure and the first capillary structure at least partially overlap.

11. A method for manufacturing a thermally conductive structure, comprising:
obtaining a thermally conductive plate;
removing impurities from a surface of the thermally conductive plate;
preparing an electrodeposition solution;
forming, by using an electrochemical deposition process, a first capillary structure on the thermally conductive plate from which the impurities are removed;
the first capillary structure has a plurality of media pores with different pore sizes, the plurality of media pores all extend along a thickness direction of the first capillary structure, and the plurality of media pores all run through the first capillary structure.

12. The manufacturing method according to claim 11, wherein the preparing an electrodeposition solution comprises: mixing sulfate, copper sulfate, and pure water.

13. The manufacturing method according to claim 12, wherein the preparing an electrodeposition solution further comprises: adding one or more of sodium chloride, sodium dodecyl acid, and sodium dodecyl sulfate to a mixture of the sulfate and the copper sulfate.

14. A heat sink, comprising a cover plate and the thermally conductive structure according to any one of claims 1 to 10, wherein a pillar is disposed between the cover plate and the thermally conductive plate, and the cover plate is fastened to the thermally conductive plate.

15. An electronic device, comprising a housing and the heat sink according to claim 14, wherein the heat sink is disposed in the housing.
